(19) Europäisches Patentamt / European Patent Office / Office européen des brevets

(11) **EP 2 593 806 B1**

(12) **FASCICULE DE BREVET EUROPEEN**

(45) Date de publication et mention de la délivrance du brevet:
**22.04.2015 Bulletin 2015/17**

(21) Numéro de dépôt: **11741670.1**

(22) Date de dépôt: **13.07.2011**

(51) Int Cl.:
*G01R 33/38* (2006.01)　　*G01R 33/383* (2006.01)
*H01F 7/02* (2006.01)　　*H01F 41/00* (2006.01)

(86) Numéro de dépôt international:
**PCT/FR2011/051682**

(87) Numéro de publication internationale:
**WO 2012/007695 (19.01.2012 Gazette 2012/03)**

(54) **DISPOSITIF D'AIMANT PERMANENT DE CREATION D'UN CHAMP MAGNETIQUE HOMOGENE DEPORTE**

PERMANENTMAGNETVORRICHTUNG ZUR ERZEUGUNG EINES EINHEITLICHEN VERSETZTEN MAGNETFELDS

PERMANENT MAGNET DEVICE FOR GENERATING AN OFFSET UNIFORM MAGNETIC FIELD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.07.2010 FR 1055813**

(43) Date de publication de la demande:
**22.05.2013 Bulletin 2013/21**

(73) Titulaire: **Commissariat à l'Énergie Atomique et aux Énergies Alternatives
75015 Paris (FR)**

(72) Inventeur: **AUBERT, Guy
F-86000 Poitiers (FR)**

(74) Mandataire: **Thévenet, Jean-Bruno et al
Cabinet Beau de Loménie
158, rue de l'Université
75340 Paris Cédex 07 (FR)**

(56) Documents cités:
**EP-A1- 0 541 653　　US-A- 5 014 032
US-A- 5 576 679**

- **HALBACH K: "DESIGN OF PERMANENT MULTIPOLE MAGNETS WITH ORIENTED RARE EARTH COBALT MATERIAL", NUCLEAR INSTRUMENTS AND METHODS, NORTH-HOLLAND PUBLISHING COMPANY. AMSTERDAM, NL, vol. 169, 1 janvier 1980 (1980-01-01), pages 1-10, XP001032085, DOI: DOI: 10.1016/0029-554X(80)90094-4 cité dans la demande**
- **HUGON C ET AL: "Design of arbitrarily homogeneous permanent magnet systems for NMR and MRI: Theory and experimental developments of a simple portable magnet", JOURNAL OF MAGNETIC RESONANCE, ACADEMIC PRESS, ORLANDO, FL, US, vol. 205, no. 1, 1 juillet 2010 (2010-07-01), pages 75-85, XP027084281, ISSN: 1090-7807 [extrait le 2010-04-10]**

**Description**

Domaine de l'invention

La présente invention a pour objet un dispositif d'aimant permanent de création d'un champ homogène déporté, pouvant être utilisé notamment dans la technique permettant de créer des images par résonance magnétique nucléaire (RMN), cette technique étant également connue sous le nom d'imagerie par résonance magnétique (IRM).
L'invention concerne également un procédé de réalisation d'un tel dispositif d'aimant permanent.

Art antérieur

L'IRM et la RMN reposent sur l'utilisation de champs magnétiques, dont un champ magnétique dit « *principal*» qui doit être aussi uniforme que possible dans la région examinée ou zone d'intérêt ZI. L'usage a consacré le qualificatif « *homogène* » pour désigner ce caractère uniforme. Ce champ magnétique de grande homogénéité est généré par des aimants dont les plus répandus aujourd'hui sont constitués de bobinages supraconducteurs qui transportent les courants électriques générant le champ sans aucune dissipation d'énergie, à condition qu'ils soient maintenus à très basse température. Un tel dispositif d'aimant a généralement l'apparence extérieure d'un tunnel cylindrique dans lequel on introduit l'objet ou le patient à imager. Les contraintes géométriques nécessaires pour réaliser l'homogénéité souhaitée dans un certain volume conduisent à le situer de préférence au centre du tunnel et la longueur de celui-ci ne peut pas être trop petite par rapport à son diamètre. Dans ces conditions, même si l'on veut construire une machine dédiée à l'examen de la tête (cerveau, sinus, dentition...), la morphologie du corps humain est telle que pour placer la tête au centre du tunnel, il faut que son diamètre soit assez grand pour permettre le passage des épaules et du thorax, c'est à dire de la totalité du corps. On dit alors que la machine est « *corps entier* ».
Comme le coût de l'aimant est environ proportionnel au cube de son diamètre, on mesure tout l'intérêt économique qu'il y a à pouvoir réaliser un aimant dont le volume d'homogénéité englobe la tête sans qu'il soit nécessaire d'y introduire les épaules. De telles considérations sont applicables à d'autres types d'utilisation dès lors qu'il y a des problèmes d'encombrement et que l'on souhaite réaliser une machine « dédiée » plutôt qu'une machine « généraliste » beaucoup plus grande et donc beaucoup plus chère.
Les matériaux magnétiques à base de fer, de cobalt et de terres rares (néodyme, samarium...) dont la production industrielle a commencé dans les années 1970 permettent de réaliser des aimants dits « permanents » produisant un champ magnétique suffisant pour la RMN ou l'IRM (quoique notablement inférieur à celui des aimants supraconducteurs), avec les qualités d'homogénéité requises. Ces aimants permanents ont également l'intérêt de contraintes d'installation et de fonctionnement beaucoup moins lourdes que celles des aimants supraconducteurs « corps entier » et peuvent de ce fait être installés plus facilement dans des cabinets médicaux.
Toutefois, comme pour les aimants supraconducteurs, la masse et le coût de l'aimant varient environ comme le cube de ses dimensions et il est donc très intéressant de pouvoir définir des configurations qui seraient dédiées à certains examens seulement mais de dimensions plus petites que celles d'un aimant « corps entier ».
La propriété la plus remarquable des matériaux à base de terres rares susmentionnés est de conserver rigidement l'aimantation $\vec{M}$ qui leur a été conférée par un processus d'aimantation approprié, tant que les champs magnétiques auxquels ils sont soumis par eux-mêmes et leur environnement ne dépassent pas certaines limites (champ coercitif). On trouvera dans l'article suivant plus de précisions sur leur utilisation ainsi qu'une façon particulière d'aimanter des couronnes pour produire un champ magnétique globalement perpendiculaire à leur axe : « Design of permanent multiple magnets with oriented rare earth cobalt material, Klaus Halbach, Nucl. Instr. And Meth. 169 , 1980, pp.1-10.
Les processus de fabrication des matériaux pour aimants permanents, notamment à base de terres rares, doivent leur conférer un grand champ coercitif et une forte anisotropie uniaxiale. Ces processus de fabrication sont pratiquement incompatibles avec l'aimantation radiale de couronnes cylindriques circulaires. On a donc déjà proposé de remplacer ces cylindres circulaires annulaires par un assemblage de $N$ prismes droits identiques, de section trapézoïdale isocèle, pour réaliser une couronne polygonale.
On connaît par exemple par le document EP 0 541 653 B1 un aimant permanent pour installation d'imagerie par résonance magnétique nucléaire qui met en oeuvre des couronnes à aimantation radiale dans une configuration symétrique par rapport à un plan médian *xOy* perpendiculaire à leur axe $O_z$. La région d'intérêt à champ homogène est alors accessible de façon perpendiculaire à l'axe au voisinage de ce plan. La structure comprend essentiellement deux grandes couronnes symétriques par rapport au plan médian, aimantées radialement en sens inverse, l'homogénéité étant réalisée au moyen d'un ensemble de couronnes plus petites, également symétriques par rapport au plan médian, avec des aimantations radiales ou axiales. On voit que dans une telle structure, l'examen d'une partie quelconque du corps humain nécessite que la distance entre les deux ensembles de couronnes situées de part et d'autre du plan médian soit assez grande pour permettre le passage du corps entier. Un tel dispositif d'aimant permanent ne répond donc pas aux exigences relatives à un dispositif compact et de fabrication aisée capable de créer un champ magnétique homogène pour l'observation notamment d'une partie dédiée du corps humain (par exemple sinus, cerveau, mâchoire, sein, etc...) sans qu'il soit nécessaire de prévoir une grande taille permettant le passage de l'ensemble d'un corps humain.

Définition et objet de l'invention

La présente invention vise à remédier aux inconvénients précités et à permettre la réalisation d'un dispositif d'aimant permanent de création d'un champ magnétique homogène déporté plus compact que les dispositifs existants tout en étant facile à réaliser et qui permette d'obtenir dans un volume d'intérêt un champ magnétique intense et très homogène capable d'être utilisé notamment pour des applications de RMN ou IRM visant à examiner des parties dédiées d'un objet ou du corps humain (comme par exemple un cerveau, une mâchoire, des sinus, un sein,...).

Par champ magnétique intense, on entend un champ magnétique au moins égal à 0,5T, de préférence supérieur ou égal à 1T, et qui dans certaines réalisations, peut dépasser 10T.

L'invention vise encore à définir un procédé de réalisation d'un tel dispositif qui soit simplifié et permette néanmoins une optimisation de l'homogénéisation du champ magnétique créé dans le volume d'intérêt.

Ces buts sont atteints, conformément à l'invention, grâce à un dispositif d'aimant permanent de création d'un champ magnétique homogène ainsi que défini par la revendication 1. Des modes de réalisation particuliers sont définis dans les revendications 2 à 12.

L'invention concerne également un procédé de réalisation d'un dispositif d'aimant permanent pour la création d'un champ magnétique homogène tel que défini par la revendication 13. Des modes de réalisation particuliers sont définis dans les revendications 14 à 16.

Brève description des dessins

D'autres caractéristiques et avantages de l'invention ressortiront de la description suivante de modes particuliers de réalisation de l'invention donnés à titre d'exemples en référence aux dessins annexés, sur lesquels :

- La Figure 1 représente une vue schématique en coupe axiale d'un mode particulier de réalisation d'un dispositif d'aimant permanent selon l'invention avec un fourreau correcteur à six éléments,
- La Figure 1A est une vue agrandie de la Figure 1 en demi-coupe axiale,
- La Figure 2 montre la variation du champ magnétique réduit en fonction de la cote réduite pour le mode de réalisation des Figures 1 et 1A,
- La Figure 3 montre l'homogénéité du champ magnétique en ppm en fonction de la cote réduite pour le mode de réalisation des Figures 1 et 1A,
- La Figure 4 représente une vue schématique en coupe axiale d'un mode particulier de réalisation d'un dispositif d'aimant permanent selon l'invention avec un fourreau correcteur à trois éléments,
- La Figure 4A est une vue agrandie de la Figure 4 en demi-coupe axiale,
- La Figure 5 montre la variation du champ magnétique réduit en fonction de la cote réduite pour le mode de réalisation des Figures 4 et 4A,
- La Figure 6 montre l'homogénéité du champ magnétique en ppm en fonction de la cote réduite pour le mode de réalisation des Figures 4 et 4A,
- La Figure 7 représente une vue schématique en coupe axiale d'un mode particulier de réalisation d'un dispositif d'aimant permanent selon l'invention avec un fourreau correcteur à sept éléments,
- La Figure 7A est une vue agrandie de la Figure 7 en demi-coupe axiale,
- La Figure 8 montre la variation du champ magnétique réduit en fonction de la cote réduite pour le mode de réalisation des Figures 7 et 7A,
- La Figure 9 montre l'homogénéité du champ magnétique en ppm en fonction de la cote réduite pour le mode de réalisation des Figures 7 et 7A,
- La Figure 10 montre une vue en plan d'un exemple de couronne polygonale pouvant être mise en oeuvre dans le dispositif d'aimant permanent selon l'invention,
- Les Figures 11 et 12 sont des représentations schématiques en coupe axiale montrant des exemples d'application du dispositif selon l'invention à une installation de RMN pour l'observation de la tête d'un patient, et
- La Figure 13 est une représentation schématique en coupe axiale montrant un exemple d'application du dispositif selon l'invention à une installation de mammographie IRM pour l'observation d'un sein d'une patiente.

Description détaillée de modes de réalisation préférentiels

La présente invention vise à résoudre notamment le problème de la réalisation d'une configuration d'aimant permanent dédiée à l'examen d'un organe particulier, tel que la tête d'un patient, sans qu'il soit nécessaire d'introduire dans la machine l'ensemble du corps du patient, de manière à réduire la taille du dispositif d'aimant. La solution proposée dans le cadre de la présente invention peut également être utilisée dans d'autres circonstances où des difficultés d'accès ou d'encombrement peuvent se poser. C'est le cas par exemple pour la réalisation de mammographies IRM où, comme cela sera explicité plus loin, seul un sein d'une patiente étendue à plat ventre peut faire l'objet d'une analyse dans un champ magnétique à l'aide d'un dispositif selon l'invention, sans que tout le corps ait besoin d'être introduit dans une machine d'observation en forme de tunnel.

Pour illustrer la forme générale d'un dispositif selon l'invention, on peut considérer un chapeau haut-de-forme.

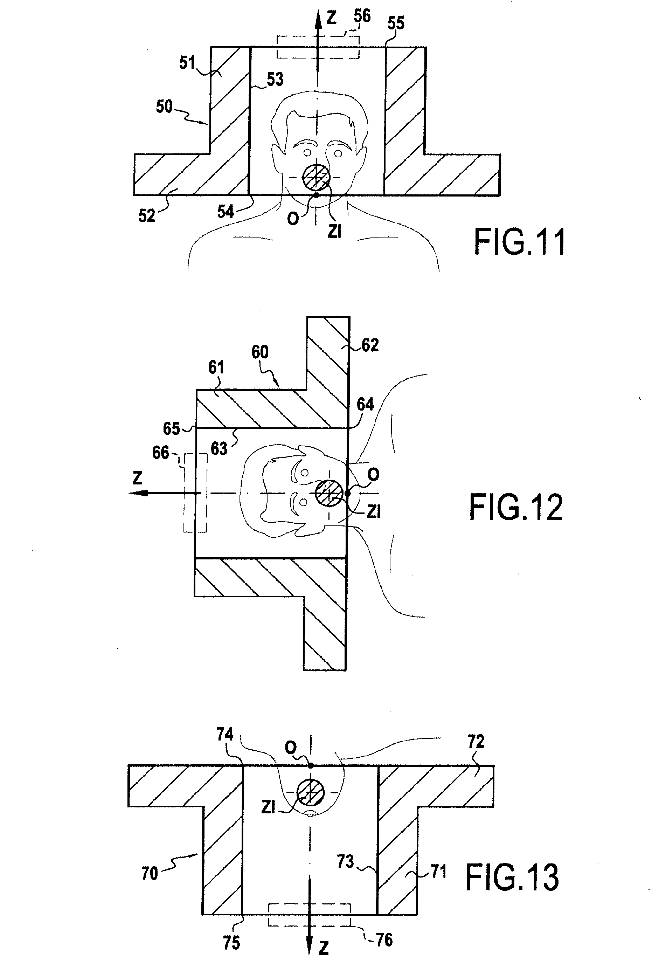

Si l'on choisit un chapeau d'une taille beaucoup plus grande que celle de la tête d'un patient, tel qu'on puisse l'enfoncer jusqu'aux épaules de ce patient, on obtient un dispositif tel que le dispositif 50 de la figure 11 avec un corps cylindrique 51 définissant un volume interne 53 d'axe Oz avec une ouverture 54 à sa partie inférieure prolongée par un rebord 52 pouvant venir juste au-dessus des épaules du patient dont la tête est engagée dans la zone d'intérêt formée dans la cavité 53. Le fond de la cavité 53 peut être obturé par un bloc 56 ou, au contraire, selon certains modes de réalisation, on peut avantageusement enlever ce bloc 56 pour former une ouverture 55 ménageant un accès par le haut permettant ainsi de disposer des éléments nécessaires à l'IRM (antennes RF, bobines de gradients...) à l'intérieur du chapeau, autour de la tête du patient. Tout l'espace symbolisé par le chapeau 50 et le rebord 52 peut recevoir des pièces aimantées destinées à produire un champ magnétique homogène selon l'axe Oz dans un certain volume utile, par exemple une zone d'intérêt englobant la mâchoire si l'on veut imager celle-ci. C'est d'ailleurs la condition la plus difficile à réaliser car il s'agit de la région de la tête la plus voisine des épaules. Si l'homogénéité est réalisée dans cette région, il suffira, pour examiner les sinus ou le cerveau, de remonter le chapeau ou, si celui-ci est maintenu par des supports appropriés, d'abaisser le patient.

Selon l'invention, on met en oeuvre des pièces aimantées constituées de couronnes annulaires coaxiales autour de l'axe Oz vertical du chapeau 50. Chaque couronne est limitée par un cylindre circulaire intérieur de rayon $a_1$, un cylindre circulaire extérieur de rayon $a_2$ et deux plans perpendiculaires à l'axe, séparés par la hauteur $h$ de la couronne.

Un tel élément caractérisé géométriquement par les trois paramètres $(a_1,a_2,h)$ sera appelé simplement « couronne » et il convient simplement de préciser par ailleurs son état d'aimantation.

Outre l'aimantation du type « dipôle de Halbach », on peut envisager d'aimanter la couronne soit parallèlement à son axe (aimantation axiale), soit perpendiculairement à son axe (aimantation radiale). Dans le cadre de la présente demande on considère une aimantation radiale qui est la plus adaptée au résultat souhaité, sauf pour un éventuel fond 56 de la cavité 53 où l'aimantation pourrait être axiale ou radiale selon les cas.

On suppose ici que les aimantations proposées sont parfaitement rigides. Dans les situations réelles, elles peuvent évidemment s'écarter légèrement de cette rigidité théorique du fait par exemple de l'imperfection des matériaux, d'erreurs lors du processus d'aimantation, de désaimantations locales... Comme pour tout type d'aimant réel, y compris les aimants supraconducteurs, les couronnes aimantées utilisées dans le cadre de la présente invention peuvent donner lieu à des corrections de réglage final par des dispositifs d'ajustement appropriés appelés « *shims* » en anglais.

On rappellera ci-dessous les propriétés magnétiques des couronnes à aimantation radiale :

Soit une couronne définie géométriquement par les quatre paramètres $(a_1,a_2,b_1,b_2)$, où $a_1$ et $a_2$ désignent respectivement le rayon intérieur et le rayon extérieur des cylindres circulaires délimitant la couronne dans un plan perpendiculaire à l'axe Oz, et la hauteur de la couronne selon l'axe Oz est donnée par $h = b_2 - b_1$ où $b_1$ et $b_2 > b_1$ sont les cotes suivant l'axe $O_z$ des plans qui limitent la couronne selon cette direction.

On montre facilement que si la couronne porte une aimantation radiale de module constant $M = |\vec{M}|$, elle produit sur son axe au point de cote $_z$, un champ magnétique parallèle à cet axe, dont la mesure algébrique a pour expression :

$$B_z = \pm \frac{\mu_0 M}{2} \left[ \left[ \frac{a}{\sqrt{a^2 + (b-z)^2}} - \text{arctanh} \frac{a}{\sqrt{a^2 + (b-z)^2}} \right]_{a_1}^{a_2} \right]_{b_1}^{b_2}$$

où le signe + correspond à une aimantation radiale dirigée de l'axe vers l'extérieur et le signe - à une aimantation radiale dirigée vers l'axe.

Si on considère à titre d'exemple la relation $\dfrac{B_z}{\mu_0 M} = f\left( \zeta = \dfrac{z}{a_1} \right)$ pour une aimantation radiale dirigée vers l'axe avec $a_2 = 2a_1, b_2 = -b_1 = \dfrac{a_1}{2}, h = a_1$ , on voit que le champ magnétique est nul au centre le la couronne (f est une fonction impaire de $\zeta$) et passe par un maximum, $\dfrac{B_0}{\mu_0 M} \approx 0{,}1836$, éloigné du centre, $\zeta_0 = 0.7845$, ce qui est précisément l'une des particularités recherchées.

Autour de ce point déporté selon l'axe Oz, il existe donc une zone approximativement homogène dans laquelle on peut réaliser de la RMN et de l'IRM sur une portion d'échantillon suffisamment petite pour que les conditions d'homogénéité requises soient remplies.

Il est à noter que pour les matériaux à base de terres rares, FeNdB par exemple, $\mu_0 M \approx 1.2\ T$ environ. Il faut donc s'attendre à obtenir avec ces aimants permanents des champs de 0.1 à 0.2 $T$ environ, soit des champs de l'ordre de ceux qui étaient utilisés avant l'introduction des aimants supraconducteurs et qui permettent déjà la réalisation d'images de qualité tout à fait satisfaisantes pour une utilisation médicale.

Selon l'invention, on procède à un processus d'optimisation qui consiste à rechercher la géométrie et les positions axiales, soit $(a_1, a_2, b_1, b_2)$, d'un ensemble de telles couronnes aimantées radialement, avec le signe $\pm$ à déterminer pour chacune d'entre elles, situées dans l'espace libre défini plus haut, telles que le champ produit en un point de l'axe Oz de position donnée par rapport au bord du chapeau (distance aux épaules) soit le plus grand possible pour un volume fixé de matériau aimanté (ou de façon équivalente, un volume de matériau minimum pour un champ fixé), tout en respectant une homogénéité fixée dans une sphère de rayon également fixé centrée en ce point.

Ceci constitue un problème classique d'optimisation non linéaire tant pour la fonction objectif (volume de matériau ou valeur du champ magnétique) que pour les contraintes, notamment l'homogénéité, avec par ailleurs des bornes sur les variables géométriques afin de respecter les contraintes spatiales. On doit toutefois prendre en compte le fait que l'aimantation radiale n'est pas une fonction continue susceptible de varier entre $\pm M$ mais ne peut prendre que l'une ou l'autre des valeurs extrêmes.

À titre d'exemple, on peut chercher quelle est la géométrie d'une seule couronne donnant le champ magnétique maximum au point de maximum sur l'axe Oz, soit $B_0 = B_z(\zeta_0)$, pour un volume $V = \pi h \left( a_2^2 - a_1^2 \right)$, sans autre contrainte. $B_0$ est évidemment une fonction croissante de $V$ mais alors que l'énergie magnétisante mise en jeu est proportionnelle à v, l'énergie magnétique utile créée est proportionnelle à $B_0^2 a_1^3$. Il doit donc exister un optimum économique qui correspond au maximum de $\dfrac{B_0^2 a_1^3}{V}$. La solution est alors entièrement déterminée au facteur géométrique d'échelle $a_1$ près.

On peut ainsi noter que c'est une propriété remarquable des configurations à aimants permanents d'être invariantes pour leurs propriétés magnétiques quand on les dilate (ou contracte) par un facteur d'échelle. On peut ainsi ajuster in fine les dimensions réelles pour obtenir l'espace libre nécessaire, sans avoir à faire de nouveaux calculs.

Par résolution numérique des équations non linéaires du problème, on trouve le résultat suivant pour cet optimum économique :

$$\frac{a_2}{a_1} \approx 1{,}7694,\ \frac{h}{a_1} \approx 1{,}6338,\ \frac{\zeta_0}{a_1} \approx 0{,}9508,\ \frac{B_0}{\mu_0 M} \approx 0{,}2169,$$

Avec une seule couronne, la zone d'homogénéité est bien déportée à l'extérieur de la couronne mais elle est très petite par rapport aux dimensions de l'aimant. La zone d'intérêt à champ assez homogène pour l'IRM peut être ainsi une sphère de rayon $\dfrac{a_1}{10}$

Afin d'augmenter la taille de la zone d'homogénéité on peut donner une définition mathématique plus précise des conditions à réaliser pour obtenir l'homogénéité:

Dans une région de l'espace « magnétiquement » vide (c'est-à-dire ne contenant ni courant électrique, ni matériau aimanté), le laplacien de chacune des composantes cartésiennes du champ magnétique est nul, ce qui implique que chacune de ces composantes est développable en harmoniques sphériques solides (DHS) sous la forme, pour la composante $B_z$ par exemple :

$$B_z = Z_0 + \sum_{n=1}^{\infty} r^n \left[ Z_n P_n \left( \cos \vartheta \right) + \sum_{m=1}^{n} \left( X_n^m \cos m\varphi + Y_n^m \sin m\varphi \right) P_n^m \left( \cos \vartheta \right) \right]$$

où $(r, \vartheta, \varphi)$ sont les coordonnées sphériques du point considéré dans un repère d'axe $O_z$ tel que $z = r \cos \vartheta$ avec $x = r \sin \vartheta \cos \varphi$ et $y = r \sin \vartheta \sin \varphi$. Les $P_n$ sont les polynômes de Legendre de degré $n$ et les $P_n^m$ sont les polynômes de Legendre associés de degré $n$ et d'ordre $m$. Ce développement est unique et valable à l'intérieur de la plus grande boule de centre $O$ magnétiquement vide.

Si la configuration des sources de champ est axisymétrique d'axe $O_z$, on obtient la forme simple suivante :

$$B_z = Z_0 + \sum_{n=1}^{\infty} r^n Z_n P_n \left( \cos \vartheta \right)$$

C'est la forme appropriée pour un ensemble de couronnes coaxiales d'axe $O_z$ à aimantation radiale. Elle se réduit à une forme encore plus simple pour $B_z(z)$ sur l'axe, soit :

$$B_z = Z_0 + \sum_{n=1}^{\infty} Z_n z^n$$

Les $Z_n$ peuvent donc s'obtenir à partir du développement en série de l'expression analytique du champ créé sur l'axe par chacune des couronnes. On peut d'ailleurs établir une relation de récurrence qui permet un calcul rapide des coefficients successifs à partir des deux premiers, $Z_1$ et $Z_2$.

Les conditions d'homogénéité prendront donc pour forme mathématique l'annulation des $n_0$ premiers coefficients, soit :

$$Z_1 = Z_2 = \cdots = Z_{n_0} = 0$$

Si ces conditions sont réalisées, on dit que l'aimant est homogène au degré (ou aussi à l'ordre) $n_0$. Comme les coefficients restants sont des fonctions décroissantes de leur degré, l'inhomogénéité de l'aimant sera principalement gouvernée par le premier terme non nul suivant $n_0$. Bien que le calcul n'ait été exécuté que sur l'axe, le fait que les coefficients $Z_n$ soient ceux du DHS valable dans toute sa boule de validité, garantit d'une part l'homogénéité de $B_z$ dans la boule, que l'on soit ou non sur l'axe, et, d'autre part, que les composantes perpendiculaires du champ soient du même ordre de grandeur que la partie inhomogène de $B_z$. Elles sont ainsi sans aucune influence sur le module du champ qui donne la fréquence de RMN et qui peut être considéré comme égal à $B_z$.

Dans les configurations qui possèdent un plan de symétrie perpendiculaire à l'axe et si l'on choisit ce plan comme étant $xOy$ ($O$ est un centre de symétrie pour l'aimant), tous les coefficients de degré impair $Z_{2p+1}$ sont identiquement nuls par raison de symétrie. Ce n'est malheureusement pas le cas pour les configurations asymétriques considérées ici et il faut alors bien annuler explicitement tous les termes successifs.

Par exemple, avec une seule couronne comme indiqué plus haut, si l'on choisit l'origine en $\zeta_0$ pour le DHS, le fait que ce point soit un maximum de $B_z$ correspond à $Z_1 = 0$ et ce sont les coefficients non nuls suivants $Z_2, Z_3, ...$ qui gouvernent l'inhomogénéité. Si l'on introduit une seconde couronne symétrique par rapport à ce point (son aimantation sera donc de signe contraire à celle de la première), on peut voir que non seulement la valeur du champ est doublée mais que l'homogénéité est fortement améliorée car les premiers termes non nuls sont maintenant $Z_4, Z_6, ...$

Outre le champ homogène produit dans le volume d'intérêt, tout aimant produit un champ extérieur dit aussi « champ de fuite » (en anglais « *stray field*»). Ce champ a des influences néfastes, notamment sur les appareils électriques ou électroniques comme les stimulateurs cardiaques, ce qui a conduit à définir une limite légale de sécurité de *5 gauss* = 50 *mT* au delà de laquelle des précautions particulières doivent être prises avec une interdiction totale aux porteurs de stimulateurs cardiaques notamment.

Comme pour l'intérieur où existent des DHS dits «*réguliers*», existent à l'extérieur de la plus petite boule magnétiquement vide (soit une boule englobant la totalité de l'aimant) des DHS pour les composantes du champ, DHS dits « *irréguliers* ». Ils sont en $\dfrac{1}{r^{n+1}}$ au lieu de $r^n$, avec comme coefficients axiaux des $M_n$ au lieu des $Z_n$. Ces coefficients

sont appelés « *moments* » et celui de degré le plus bas est le moment dipolaire $M_2$ car les monopôles magnétiques n'existent pas (du moins dans ce contexte).

Les méthodes de réduction du champ extérieur sont analogues à celles utilisées pour l'homogénéisation et consistent à annuler les moments successifs, le plus souvent en se limitant à $M_2 = 0$, tout en annulant simultanément les $n_0$ premiers $Z_n$ à partir de n=1 pour obtenir l'homogénéité souhaitée.

Une caractéristique très intéressante des couronnes à aimantation radiale est que leur moment dipolaire est identiquement nul, ce qui réduit donc, sans effort particulier, le champ extérieur.

Pour tenir compte de ce qui précède, conformément à l'invention, on met en oeuvre plusieurs couronnes coaxiales à aimantation radiale et dont l'aimantation est orientée selon un sens prédéfini.

Par ailleurs, les processus de fabrication des matériaux pour aimants permanents, notamment à base de terres rares, doivent leur conférer un grand champ coercitif et une forte anisotropie uniaxiale. Ces processus peuvent présenter des incompatibilités avec l'aimantation radiale des couronnes. C'est pourquoi selon un aspect de l'invention, pour faciliter la réalisation, on remplace les cylindres circulaires annulaires par un assemblage de $N$ prismes droits identiques, de section trapézoïdale isocèle, pour réaliser une couronne polygonale.

Les sommets intérieurs et extérieurs des prismes sont situés sur des cylindres circulaires d'axe $O_z$ de rayons $a_1$ et $a_2 > a_1$ respectivement. Les prismes sont situés entre les plans perpendiculaires à $O_z$ de cotes $b_1$ et $b_2 > b_1$. Leur ouverture angulaire est égale à $2\varphi_0 = \dfrac{2\pi}{N}$. Chaque prisme a une aimantation uniforme $\vec{M} = M\vec{u_\perp}$ perpendiculaire à l'axe $O_z$ et suivant la bissectrice de l'ouverture angulaire de chaque prisme, c.-à-d. perpendiculaire aux deux faces rectangulaires, intérieure et extérieure, orientée de l'intérieur vers l'extérieur ou inversement.

On établit tout d'abord l'expression de la composante axiale du champ sur l'axe :

$$B_z\left(\rho = 0, z\right) = \left\{\left\{f\left[a, (b-z)\right]\right\}_{a_1}^{a_2}\right\}_{b_1}^{b_2}.$$

Les coefficients axiaux $Z_n$ du DHS de la composante $B_z$ s'en déduisent par les relations :

$$Z_0 = B_z\left(\rho = 0, z = 0\right) = \left[\left[f\left(a, b\right)\right]_{a_1}^{a_2}\right]_{b_1}^{b_2}$$

$$Z_n = -\frac{1}{n}\left[\left[\frac{\partial Z_{n-1}}{\partial b}\right]_{a_1}^{a_2}\right]_{b_1}^{b_2}$$

Les premiers termes non-axiaux résultant de cette segmentation sont beaucoup plus difficiles à calculer mais ils n'apparaissent qu'à l'ordre $N$ qu'il suffira de prendre assez grand pour que la recherche de l'homogénéité ne porte que sur les termes axiaux.

Un calcul classique de magnétostatique conduit à l'expression suivante :

$$B_z\left(\rho = 0, z\right) = \pm N\frac{\mu_0 M}{2\pi}\left[\left[\operatorname{arctanh}\frac{a\sin\varphi_0}{\sqrt{a^2 + \left(b-z\right)^2}} - \sin\varphi_0 \operatorname{arctanh}\frac{a}{\sqrt{a^2 + \left(b-z\right)^2}}\right]_{a_1}^{a_2}\right]$$

où le signe + correspond à une aimantation radiale dirigée de l'axe vers l'extérieur et le signe - à une aimantation radiale dirigée vers l'axe.

On en déduit :

$$Z_0 = \pm N \frac{\mu_0 M}{2\pi} \left[ \left[ \operatorname{arctanh} \frac{a \sin \varphi_0}{\sqrt{a^2 + b^2}} - \sin \varphi_0 \operatorname{arctanh} \frac{a}{\sqrt{a^2 + b^2}} \right]_{a_1}^{a_2} \right]_{b_1}^{b_2}$$

On vérifie alors que si l'on fait $N \to \infty$ avec $\varphi_0 = \dfrac{\pi}{N}$ on retrouve bien les expressions obtenues pour le cylindre annulaire :

$$B_z = \pm \frac{\mu_0 M}{2} \left[ \left[ \frac{a}{\sqrt{a^2 + (b-z)^2}} - \operatorname{arctanh} \frac{a}{\sqrt{a^2 + (b-z)^2}} \right]_{a_1}^{a_2} \right]_{b_1}^{b_2}$$

$$Z_0 = \pm \frac{\mu_0 M}{2} \left[ \left[ \frac{a}{\sqrt{a^2 + b^2}} - \operatorname{arctanh} \frac{a}{\sqrt{a^2 + b^2}} \right]_{a_1}^{a_2} \right]_{b_1}^{b_2}$$

Les calculs d'homogénéité pour les couronnes polygonales sont donc très semblables à ceux effectués pour les couronnes circulaires. En pratique, on détermine la configuration avec des couronnes circulaires puis on la modifie légèrement, dans une dernière étape, en utilisant les expressions relatives aux couronnes polygonales.

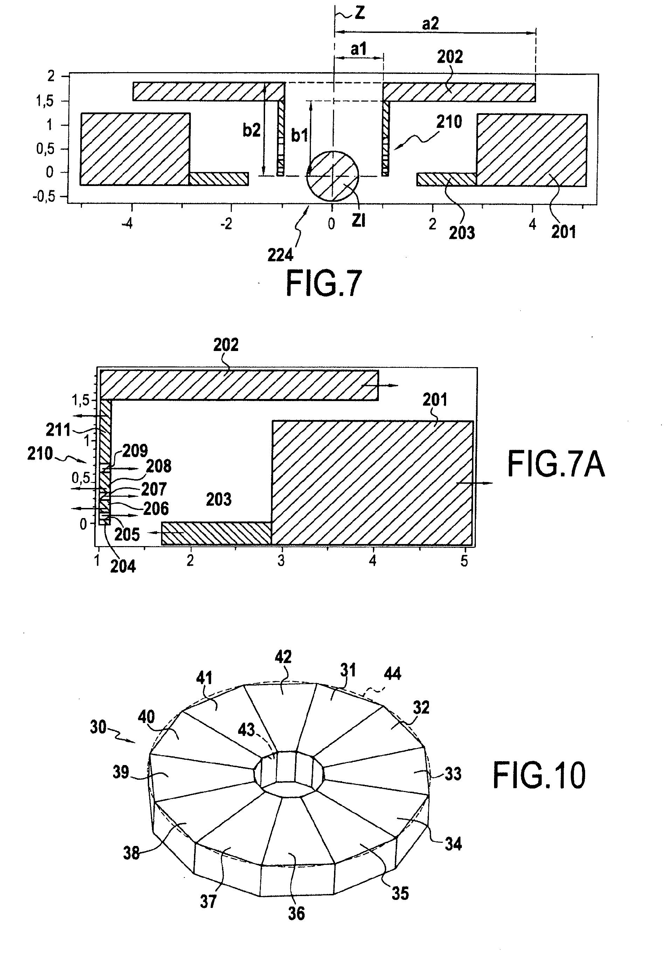

La figure 10 montre en vue en plan perpendiculaire à l'axe d'un exemple de couronne polygonale 30 avec $N$ = 12, $\dfrac{a_2}{a_1} = 4$ (rayons des cercles 43, 44) et une hauteur totale $h = 2$ .

Dans cet exemple de réalisation, la couronne polygonale 30 approximant une couronne cylindrique comprend donc douze éléments constitutifs 31 à 42 constitués par des prismes droits identiques de section trapézoïdale isocèle. Le nombre N peut naturellement être différent de douze et peut par exemple être égal à huit ou dix.

Selon l'invention, le dispositif d'aimant asymétrique peut ainsi avantageusement être réalisé *in fine* au moyen de couronnes polygonales, typiquement des dodécagones, mais on peut aussi se limiter à des octogones. Dans la suite on désignera les couronnes polygonales simplement par « *couronnes* » et on les représentera comme circulaires.

On a déjà vu plus haut que l'on pouvait, avec une seule couronne, obtenir une région d'homogénéité nettement décalée par rapport au centre de la couronne, mais cette région d'homogénéité s'avère trop petite en pratique. C'est pourquoi selon l'invention, on dispose plusieurs couronnes de même axe $O_z$ avec des aimantations radiales dans l'un ou l'autre des deux sens possibles de telle façon que les $n_0$ premiers $Z_n$ du DHS régulier après n=1 soient nuls, de manière à augmenter de façon très importante les dimensions de la région d'homogénéité. Comme on l'a vu *supra,* les propriétés magnétiques de ces configurations d'aimants permanents se conservent dans une homothétie de rapport quelconque. Il suffit donc de déterminer la structure pour un rayon intérieur libre unité et de réaliser ensuite l'homothétie nécessaire pour obtenir les valeurs souhaitées du rayon libre $a_1$ réel et de la taille de la région homogène ainsi que du décalage de celle-ci par rapport au bord de la structure.

La configuration proposée ne dépend donc que de trois paramètres, pour un rayon $a_1 = 1$, la valeur du champ magnétique au centre O de la région d'intérêt relatif à l'aimantation du matériau utilisé, soit $\dfrac{B_0}{\mu_0 M}$, le degré $n_0$ d'homogénéité tel que $Z_1 = Z_2 = \cdots = Z_{n_0} = 0$ dont on déduira les dimensions de la région homogène à $x\,ppm$ près, la cote $\beta_0$ du plan limitant la région de l'espace occupée par les aimants, c'est à dire la région $\zeta \geq \beta_0$. Le volume minimum $V_0$ de matériau nécessaire dans ces conditions est une fonction $V_0\left(\dfrac{B_0}{\mu_0 M}, n_0, \beta_0\right)$, croissante des deux premiers paramètres et décroissante du troisième. En d'autres termes, le volume de matériau et donc le coût de l'aimant augmente avec le champ et le degré d'homogénéité ainsi qu'avec l'éloignement de la région homogène de la région occupée par les aimants. Bien entendu, au delà de certaines valeurs de ces paramètres, il n'existe plus de solution. Le volume réel de matériau sera $V_0 a_1^3$, une fois choisi le rayon réel $a_1$.

Pour réaliser une région d'homogénéité à *x ppm* près de dimensions données, on a le choix, compte tenu de la propriété d'homothétie, entre augmenter $a_1$ et augmenter $n_0$ pour un rayon $a_1$ suffisant par ailleurs pour ménager l'accès et le décalage $\beta_0 a_1$ souhaités. Il est toujours beaucoup plus économique d'augmenter $n_0$, ce qui conduit à une structure plus complexe mais de moindre volume.

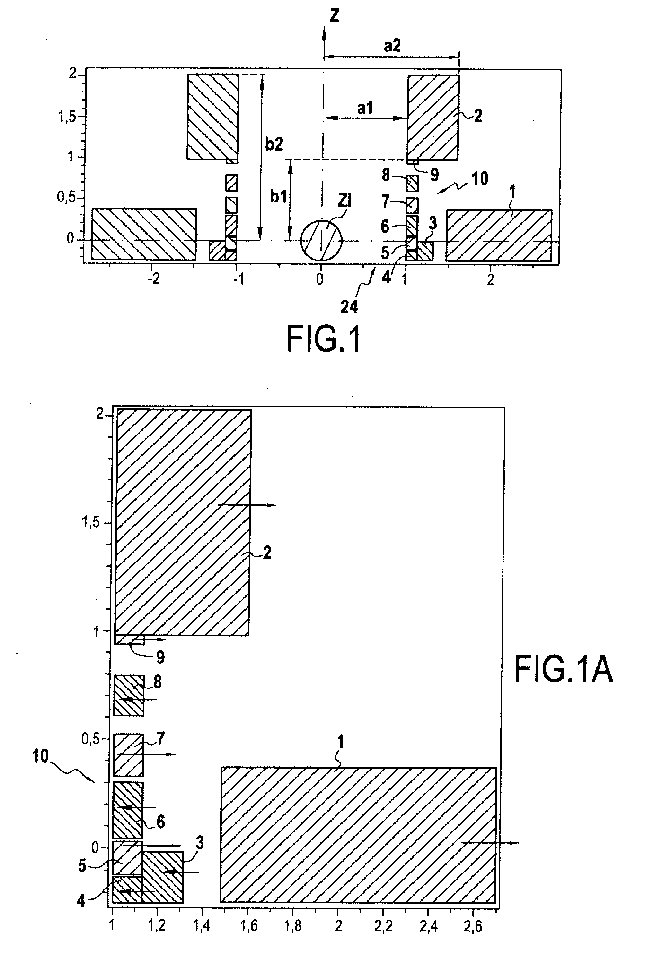

Suivant les valeurs choisies pour les paramètres, le processus d'optimisation conduit à une grande variété de configurations dont l'exemple ci-dessous illustré sur les figures 1 et 1A permettra de définir les caractéristiques communes selon l'invention. Elles correspondent aux valeurs suivantes des paramètres, fixées *a priori* :

$$\frac{B_0}{\mu_0 M} = 0.09$$

$$n_0 = 7$$

$$\beta_0 = -0.25$$

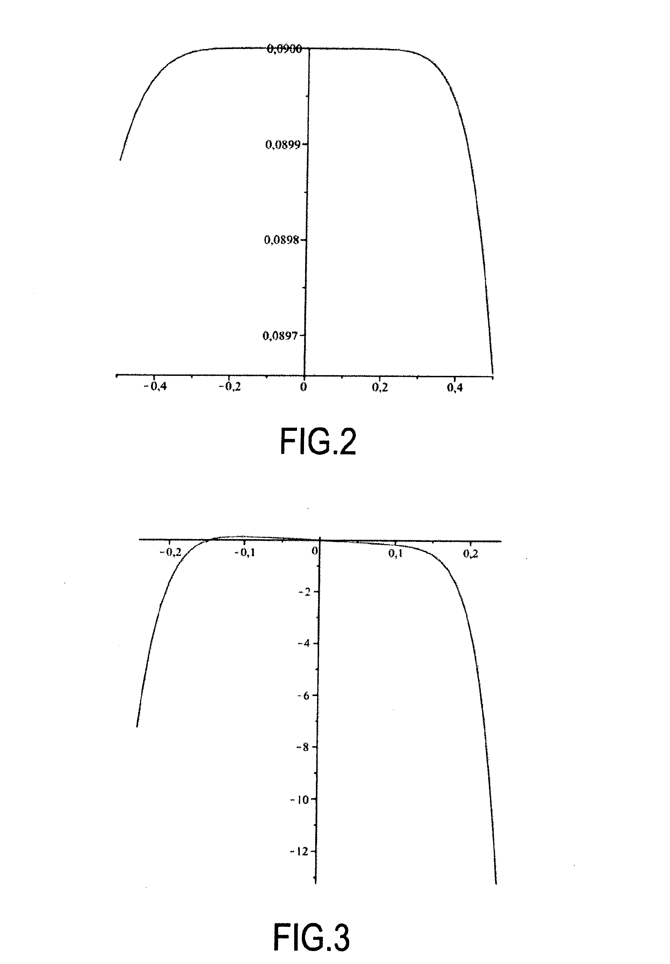

La valeur du champ réel obtenu avec du FeNdB dépassera donc 0.1 *T* = 1000 *gauss,* valeur nécessaire pour réaliser des images de qualité suffisante. $n_0$ = 7 est déjà un degré d'homogénéité élevé compatible avec des couronnes au moins octogonales qui donneront des termes d'inhomogénéité non axiaux à partir du degré 8. Si l'on choisit $a_1$ = 0.3 *m* afin d'avoir un diamètre libre de 60 *cm* pour « loger » la tête, les bobines de gradients et les antennes, on aura $\beta_0 a_1$ = -7.5 *cm ,* ce qui place le centre de la zone d'intérêt ZI au niveau de la mâchoire inférieure, si le bord du chapeau touche les épaules. Le diamètre de la boule d'homogénéité théorique à 10 *ppm* obtenu dans ces conditions est d'environ 15 *cm* comme le montrent les courbes des figures 2 et 3. L'optimisation de la structure conduit à $V_0$ = 16.198, soit 0.437 $m^3$ de matériau pour le diamètre libre choisi.

La figure 1 montre une coupe passant par l'axe Oz de la structure avec un accès libre 24 de rayon unité. La boule d'homogénéité à 10 *ppm* constituant la zone d'intérêt ZI a pour rayon 0.25 et s'étend donc jusqu'à la limite inférieure de la structure ($\beta_0$ = -0.25 ). Les différentes couronnes présentent des aimantations radiales de sens différent, par exemple depuis l'axe vers l'extérieur et vers l'axe pour un champ magnétique résultant Bz dirigé dans le sens vertical ascendant.

Bien que les dimensions des couronnes varient en fonction du choix des paramètres, on retrouve les éléments suivants représentés sur la figure 1A qui reprend de façon agrandie la partie droite de la coupe de la figure 1 :

i) deux couronnes principales 1 et 2 aimantées dans la même direction, à la différence des couronnes principales de la structure symétrique de l'art antérieur constitué par le document EP 0 541 653 B1. La couronne 1 est « collée » à la limite inférieure fixée, et la couronne 2 est située plus haut, « collée » au rayon intérieur libre. Avec seulement ces deux couronnes principales 1 et 2, on ne peut pas dépasser le degré d'homogénéité $n_0$ = 3 alors qu'une seule couronne permet $n_0$ = 2 comme rappelé plus haut.

ii) un certain nombre de couronnes 4 à 9 d'aimantations alternées, se succédant avec des épaisseurs et des espacements variables résultant du calcul. Le nombre de couronnes nécessaires croît avec $n_0$. Leur rayon intérieur est le rayon limite unité et pour des raisons de simplicité de construction, on leur impose le même rayon extérieur pour constituer une sorte de « *fourreau de couronnes correctrices* » 10 qui peut facilement être démonté pour en modifier les espacements entre couronnes si la cartographie de l'aimant réalisé en montre la nécessité. On peut également réaliser ce fourreau avec des couronnes géométriquement identiques, aimantées dans un sens ou dans l'autre, d'épaisseur assez petite afin de réaliser la structure souhaitée en les empilant avec des couronnes non magnétiques usinées à l'épaisseur souhaitée ;

iii) pour $n_0$ > 5 ou 6 suivant les valeurs des autres paramètres, il est nécessaire d'introduire une couronne supplémentaire 3, aimantée en sens inverse des couronnes principales 1 et 2 et limitée en cote inférieure par $\beta_0$ et en rayon intérieur par le rayon extérieur du fourreau précédent 10.

Les figures 2 et 3 montrent respectivement la variation du champ réduit et l'homogénéité en *ppm* en fonction de la cote réduite $\zeta$.

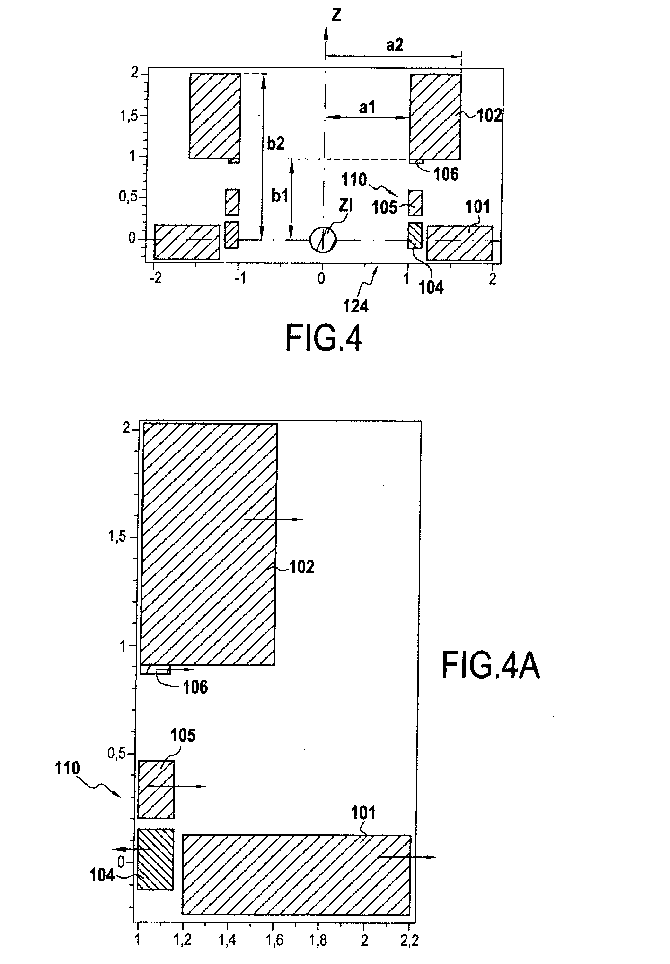

Pour montrer l'évolution de la structure en fonction du degré d'homogénéité choisi, on trouvera tout d'abord les figures 4 et 4A relatives à un mode de réalisation correspondant à $n_0$ = 4 qui conduit à $V_0$ = 8.844, soit un volume de matériau moitié du volume précédent et une boule d'homogénéité ZI de rayon 0.11. On voit sur ces figures 4 et 4A que l'on peut se passer de la couronne d'aimantation inverse correspondant à la couronne 3 des figures 1 et 1A et qu'un fourreau correcteur 110 de trois couronnes 104, 105, 106 d'aimantations alternées est suffisant et pourrait même être réductible aux deux couronnes 104, 105 au prix d'une très légère augmentation de volume. Sur les figures 4 et 4A, les couronnes principales 101 et 102 correspondent aux couronnes 1 et 2 des figures 1 et 1A, et l'ouverture inférieure du dispositif 124 correspond à l'ouverture 24 du mode de réalisation des figures 1 et 1A.

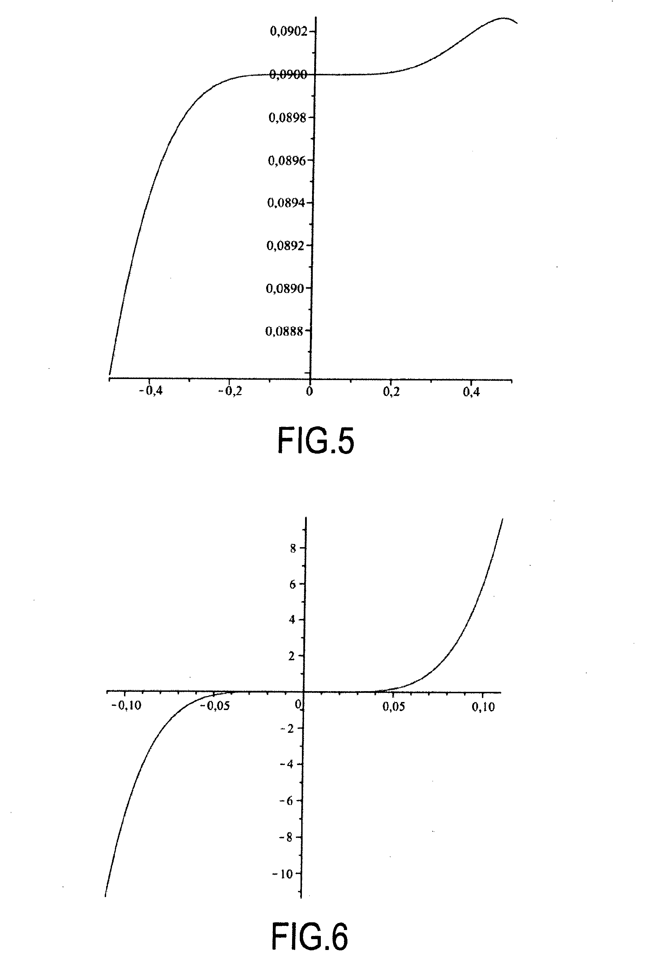

Les figures 5 et 6 relatives au mode de réalisation des figures 4 et 4A correspondent aux figures 2 et 3 relatives au mode de réalisation des figures 1 et 1A.

Pour illustrer un degré d'homogénéité beaucoup plus grand, on a représenté sur les figures 7 et 7A un mode de réalisation correspondant à $n_0$ = 11, compatible avec des couronnes au moins dodécagonales, qui conduit à $V_0$ = 104.646, soit un volume de matériau important mais une boule d'homogénéité ZI aussi très importante de rayon 0.5 centrée en -0.05.

Sur le mode de réalisation des figures 7 et 7A, on trouve des couronnes principales 201 et 202 correspondant respectivement aux couronnes 1 et 2 des figures 1 et 1A et aux couronnes 101 et 102 des figures 4 et 4A. On voit également une couronne de correction 203 qui correspond à la couronne 3 des figures 1 et 1A, avec une aimantation radiale orientée selon un sens opposé au sens d'aimantation des couronnes principales 201 et 202.
Dans le mode de réalisation des figures 7 et 7A, le fourreau cylindrique correcteur 210 comprend sept couronnes complémentaires superposées 204, 205, 206, 207, 208, 209 et 211 en matériau magnétique avec une aimantation radiale qui pour chaque couronne complémentaire successive est orientée alternativement selon un sens opposé au premier sens d'aimantation des deux couronnes principales 201 et 202 (couronnes complémentaires 204, 206, 208 et 211) et selon ce premier sens (couronnes 205, 207 et 209).

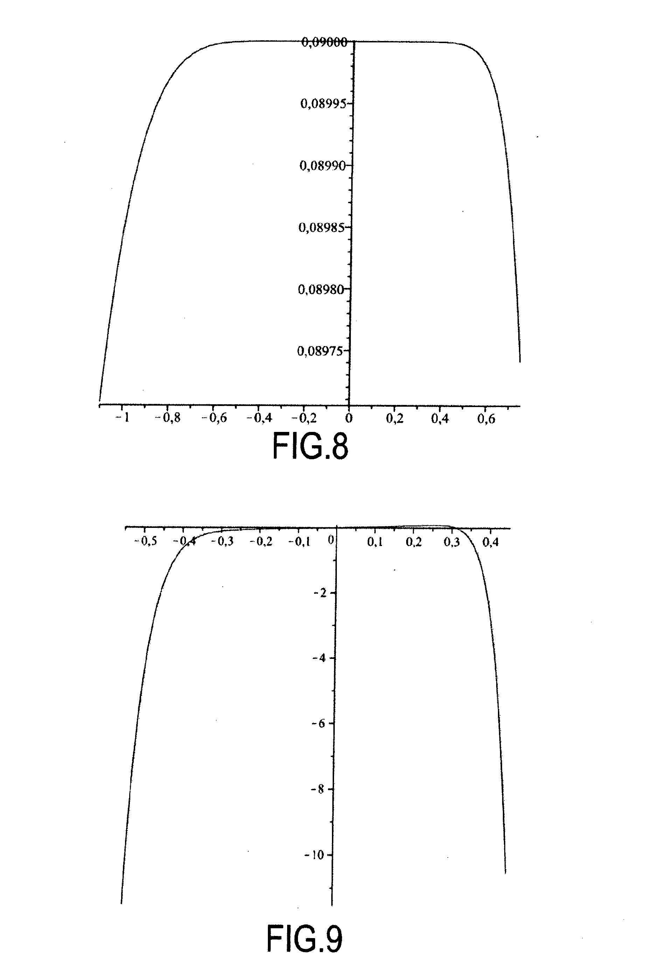

Les figures 8 et 9 relatives au mode de réalisation des figures 7 et 7A correspondent aux figures 2 et 3 relatives au mode de réalisation des figures 1 et 1A ou aux figures 5 et 6 relatives au mode de réalisation des figures 4 et 4A.

Sur les différents exemples donnés en référence aux figures 1, 1A, 4, 4A, 7, 7A, on voit que le rayon interne a2 (ou a21) et le rayon externe a2 (ou a22) de la deuxième couronne principale 2; 102; 202 sont respectivement inférieurs au rayon interne a1 (ou a11) et au rayon externe a2 (ou a12) de la première couronne principale 1; 101; 201.

Dans le mode de réalisation des figures 1 et 1A, les couronnes 1, 2, 5, 7 et 9 matérialisées par des hachures ayant une première inclinaison présentent une aimantation radiale orientée selon un premier sens (figuré par des flèches ayant une première orientation) tandis que les couronnes 3, 4, 6 et 8 matérialisées par des hachures ayant une deuxième inclinaison présentent une aimantation radiale orientée dans le sens opposé à ce premier sens (figuré par des flèches ayant une orientation opposée à la première orientation).

Dans le mode de réalisation des figures 4 et 4A, les couronnes 101, 102, 105 et 106 matérialisées par des hachures ayant une première inclinaison présentent une aimantation radiale orientée selon un premier sens (figuré par des flèches ayant une première orientation) tandis que la couronne 104 matérialisée par des hachures ayant une deuxième inclinaison présente une aimantation radiale orientée dans le sens opposé à ce premier sens (figuré par une flèche ayant une orientation opposée à la première orientation).

Dans le mode de réalisation des figures 7 et 7A, les couronnes 201, 202, 205, 207 et 209 matérialisées par des hachures ayant une première inclinaison présentent une aimantation radiale orientée selon un premier sens (figuré par des flèches ayant une première orientation) tandis que les couronnes 203, 204, 206, 208 et 211 matérialisées par des hachures ayant une deuxième inclinaison présentent une aimantation radiale orientée dans le sens opposé à ce premier sens (figuré par une flèche ayant une orientation opposée à la première orientation).

Comme on l'a déjà indiqué plus haut, selon une caractéristique avantageuse, les couronnes complémentaires superposées 4 à 9; 104 à 106; 204 à 209, 211 composant le fourreau cylindrique correcteur 10 ; 110 ; 210 présentent le même rayon interne et le même rayon externe et le fourreau cylindrique correcteur 10 ; 110 ; 210 comprend en outre des couronnes intercalaires en matériau non magnétique, pour ajuster l'espacement (l'espace libre dans le sens axial représenté sur les figures 1, 1A et 4, 4A) entre les couronnes complémentaires superposées 4 à 9; 104 à 106; 204 à 209, 211 en matériau magnétique qui présentent elles-mêmes une aimantation radiale qui pour chaque couronne complémentaire successive est orientée alternativement selon des sens opposés. Dans un tel fourreau cylindrique correcteur 10 ; 110 ; 210, la couronne complémentaire 4 ; 104 ; 204 la plus proche de l'ouverture 24 ; 124 ; 224 et de la zone d'intérêt ZI présente un sens d'aimantation radiale opposé à celui de la couronne principale 1 ; 101 ; 201 qui s'étend autour de l'ouverture 24 ; 124 ; 224 d'accès à la zone d'intérêt.

Les figures 11 et 12 montrent de façon schématique une structure 50 ; 60 en forme de chapeau haut-de-forme selon l'invention pouvant par exemple symboliser l'espace occupé par l'un ou l'autre des dispositifs d'aimant permanent décrits en référence aux figures 1, 1A, 4, 4A, 7, 7A et présentant un rebord 52 ; 62 définissant une ouverture 54 ; 64 et une cheminée cylindrique 51 ; 61 d'axe Oz prolongeant cette ouverture 54 ; 64 et définissant une cavité interne 53 ; 63 pour permettre l'analyse de la tête ou d'une partie de la tête d'un patient.

Sur la figure 11, on a représenté une structure 50 en position verticale avec l'ouverture 54 située en bas, tandis que sur la figure 12, on a représenté une structure 60 en position horizontale avec l'ouverture 64 située latéralement.

La figure 13 montre une structure 70 analogue aux structures 50 et 60 mais appliquée à une installation de mammographie IRM. La structure 70 présente une forme de chapeau haut-de-forme inversé présentant un rebord 72 définissant une ouverture supérieure 74 et un puits cylindrique 71 d'axe Oz prolongeant cette ouverture 74 et définissant une cavité interne 73 pour permettre l'analyse d'un sein ou d'une partie du sein d'une patiente placée à plat ventre, le sein pendant dans la cavité 73 sous l'effet de la gravité.

La structure 50 ; 60 ou 70 représentant le dispositif d'aimant selon l'invention peut être en position fixe et disposée en regard d'un support d'un objet ou d'un patient pouvant se déplacer par rapport au dispositif d'aimant permanent pour amener l'objet ou l'organe du patient le long de l'axe Oz dans la zone d'intérêt sphérique ZI, mais selon une variante, c'est la structure 50 ; 60 ; 70 elle-même qui peut être mobile selon l'axe Oz pour venir se positionner par rapport à un objet ou une partie du corps d'un patient.

Dans la structure 50 ; 60 ou 70, le fond du chapeau haut-de-forme, c'est-à-dire l'espace libre 55 ; 65 ; 75 au centre de la deuxième couronne principale 2 ; 102 ; 202 du dispositif d'aimant permanent, peut rester ouvert ou être obturé au moins partiellement par un bloc cylindrique supplémentaire (blocs 56, 66 et 76 représentés en pointillés sur les figures 11, 12 et 13 respectivement) en matériau magnétique avec une aimantation axiale selon l'axe Oz.

L'invention concerne également un procédé de réalisation d'un dispositif d'aimant permanent pour la création d'un champ magnétique homogène déporté avec génération d'une composante de champ magnétique homogène Bz selon un axe Oz dans une zone d'intérêt sphérique ZI de centre O et de rayon r, comprenant les étapes suivantes :

a) préparer et positionner au moins une première couronne principale 1; 101; 201 en matériau magnétique avec une aimantation radiale orientée selon un premier sens, ayant l'axe Oz, un premier rayon interne a11, un premier rayon externe a12 et s'étendant autour d'une ouverture 24; 124; 224 d'accès à la zone d'intérêt ZI,

b) préparer et positionner une deuxième couronne principale 2; 102; 202 en matériau magnétique avec une aimantation radiale orientée selon le premier sens, ayant l'axe Oz, un deuxième rayon interne a21, un deuxième rayon externe a22 et déportée selon l'axe Oz par rapport à la première couronne 1; 101; 201 et la zone d'intérêt ZI, le deuxième rayon interne a21 et le deuxième rayon externe a22 de la deuxième couronne principale 2; 102; 202 étant respectivement inférieurs au premier rayon interne a11 et au premier rayon externe a12 de la première couronne principale 1; 101; 201, et

c) préparer et positionner un fourreau cylindrique correcteur 10; 110; 210 d'axe Oz disposé d'une part entre la première couronne principale 1; 101; 201 et la zone d'intérêt ZI et d'autre part entre la deuxième couronne principale 2; 102; 202 et la zone d'intérêt ZI et comprenant à partir du voisinage de l'ouverture 24; 124; 224 au moins une première couronne complémentaire 4; 104; 204 en matériau magnétique avec une aimantation radiale orientée selon un sens opposé au premier sens, et au moins une deuxième couronne complémentaire 5; 105; 205 en matériau magnétique avec une aimantation radiale orientée selon le premier sens.

Par ailleurs, pour ajuster l'espacement entre les couronnes complémentaires 4 à 9 ; 104, 105 ; 204 à 209, 211 on peut intercaler dans le fourreau cylindrique correcteur 10 ; 110 ; 210 des couronnes intercalaires en matériau non magnétique.

Selon ce procédé, on réalise au moins certaines des couronnes annulaires en matériau magnétique sous forme de couronnes polygonales définies par des cylindres circulaires approchés par des lignes polygonales et réalisées à partir d'un assemblage de N prismes droits identiques 31 à 42 (voir figure 10) de section trapézoïdale isocèle.

La réalisation d'une couronne polygonale peut être effectuée selon les étapes suivantes :

i) fabrication par pressage ou frittage de blocs parallélépipédiques possédant une direction privilégiée d'aimantation;
ii) taille des blocs parallélépipédiques à l'état désaimanté pour créer des prismes;
iii) aimantation de chacun des prismes dans la direction souhaitée ;
iv) assemblage et collage des prismes pour créer une couronne polygonale.

Sur les dessins on a représenté des couronnes correctrices d'épaisseurs différentes au sein d'un même fourreau 10 ; 110 ; 210. Pour faciliter la réalisation et éviter des usinages difficiles de matériau magnétique, il est possible de constituer des couronnes correctrices d'épaisseurs différentes à partir d'un empilement de couronnes correctrices élémentaires à aimantation radiale selon un sens donné et présentant une épaisseur réduite unique. Chaque couronne correctrice 4 à 9 ; 104 à 106 ; 204 à 209, 211 peut ainsi elle-même être réalisée à partir d'un empilement de couronnes correctrices élémentaires présentant l'un ou l'autre des sens d'orientation de l'aimantation radiale.

**Revendications**

1. Dispositif d'aimant permanent de création d'un champ magnétique homogène pour générer une composante de champ magnétique homogène Bz selon un axe Oz dans une zone d'intérêt sphérique ZI de centre O et de rayon r, ledit dispositif comprenant au moins une première couronne principale (1; 101; 201) annulaire en matériau magnétique avec une aimantation radiale orientée selon un premier sens, ayant ledit axe Oz, un premier rayon interne (a11), un premier rayon externe (a12) et s'étendant autour d'une ouverture (24; 124; 224) d'accès à ladite zone d'intérêt ZI, une deuxième couronne principale (2; 102; 202) annulaire en matériau magnétique avec une aimantation radiale orientée selon ledit premier sens, ayant ledit axe Oz, un deuxième rayon interne (a21), un deuxième rayon externe (a22) et déportée selon ledit axe Oz par rapport à ladite première couronne (1; 101; 201) et ladite zone d'intérêt ZI, le deuxième rayon interne (a21) et le deuxième rayon externe (a22) de la deuxième couronne principale (2; 102; 202) étant respectivement inférieurs au premier rayon interne (a11) et au premier rayon externe (a12) de la première couronne principale (1; 101; 201), et un ensemble cylindrique correcteur (10; 110; 210) d'axe Oz disposé d'une part entre la première couronne principale (1; 101; 201) et la zone d'intérêt ZI et d'autre part entre la deuxième couronne principale (2; 102; 202) et la zone d'intérêt ZI et comprenant à partir du voisinage de ladite ouverture (24; 124; 224) au moins une première couronne complémentaire (4; 104; 204) annulaire en matériau magnétique avec une aimantation radiale orientée selon un sens opposé audit premier sens, et au moins une deuxième couronne complémentaire (5; 105; 205) annulaire en matériau magnétique avec une aimantation radiale orientée selon ledit premier sens, et tel que les couronnes complémentaires superposées (4 à 9; 104 à 106 ; 204 à 209, 211) composant ledit ensemble cylindrique correcteur (10 ; 110 ; 210) présentant le même rayon interne et le même rayon externe, ledit dispositif étant **caractérisé en ce que** ledit même rayon interne des couronnes complémentaires superposées (4 à 9 ; 104 à 106 ; 204 à 209, 211) est égal au deuxième rayon interne (a21) de la couronne principale (2 ; 102 ; 202) annulaire et **en ce que** ledit même rayon externe des couronnes complémentaires superposées (4 à 9 ; 104 à 106 ; 204 à 209, 211) est inférieur au premier rayon interne (a11) de la première couronne principale (1 ; 101 ; 201) annulaire.

2. Dispositif d'aimant permanent selon la revendication 1, **caractérisé en ce qu'**il comprend en outre une couronne de correction (3; 203) annulaire d'axe Oz en matériau magnétique avec une aimantation radiale orientée selon un sens opposé audit premier sens, disposée entre ladite première couronne principale (1; 201) annulaire et ledit ensemble cylindrique correcteur (10; 210).

3. Dispositif d'aimant permanent selon la revendication 1 ou la revendication 2, **caractérisé en ce que** l'ensemble cylindrique correcteur (10) comprend six couronnes complémentaires superposées (4 à 9) en matériau magnétique avec une aimantation radiale qui pour chaque couronne complémentaire successive est orientée alternativement selon un sens opposé audit premier sens et selon ledit premier sens, lesdites six couronnes complémentaires superposées (4 à 9) incluant lesdites première et deuxième couronnes complémentaires (4, 5).

4. Dispositif d'aimant permanent selon l'une quelconque des revendications 1 à 3, **caractérisé en ce que** ledit ensemble cylindrique correcteur (10 ; 110 ; 210) comprend en outre des couronnes intercalaires en matériau non magnétique pour ajuster l'espacement entre les couronnes complémentaires superposées (4 à 9; 104 à 106; 204 à 209, 211) en matériau magnétique avec une aimantation radiale qui pour chaque couronne complémentaire successive est orientée alternativement selon un sens opposé audit premier sens et selon ledit premier sens.

5. Dispositif d'aimant permanent selon l'une quelconque des revendications 1 à 4, **caractérisé en ce qu'** au moins certaines des couronnes annulaires en matériau magnétique sont constituées par des couronnes polygonales définies par des cylindres circulaires approchés par des lignes polygonales et réalisées à partir d'un assemblage de N prismes droits identiques (31 à 42) ayant une base trapézoïdale isocèle.

6. Dispositif d'aimant permanent selon la revendication 5, **caractérisé en ce que** les première et deuxième couronnes principales (1,2 ; 101, 102 ; 201, 202) sont constituées par des couronnes polygonales comprenant 8, 10 ou 12 prismes droits identiques ayant une base trapézoïdale isocèle (31 à 42).

7. Dispositif d'aimant permanent selon l'une quelconque des revendications 1 à 6, **caractérisé en ce qu'**il est appliqué à une installation de RMN et présente une forme de chapeau haut-de-forme (50 ; 60) présentant un rebord (52 ; 62) définissant une ouverture (54 ; 64) et une cheminée cylindrique (51 ; 61) d'axe Oz prolongeant ladite ouverture (54 ; 64) et définissant une cavité interne (53 ; 63) pour permettre l'analyse de la tête ou d'une partie de la tête d'un patient.

8. Dispositif d'aimant permanent selon la revendication 7, **caractérisé en ce qu'**il est installé en position verticale avec l'ouverture (54) située en bas.

9. Dispositif d'aimant permanent selon la revendication 7, **caractérisé en ce qu'**il est installé en position horizontale avec l'ouverture (64) située latéralement.

10. Dispositif d'aimant permanent selon l'une quelconque des revendications 1 à 6, **caractérisé en ce qu'**il est appliqué à une installation de mammographie IRM et présente une forme de chapeau haut-de-forme inversé (70) présentant un rebord (72) définissant une ouverture supérieure (74) et un puits cylindrique (71) d'axe Oz prolongeant ladite ouverture (74) et définissant une cavité interne (73) pour permettre l'analyse d'un sein ou d'une partie du sein d'une patiente.

11. Dispositif d'aimant permanent selon l'une quelconque des revendications 1 à 10, **caractérisé en ce qu'**il est en position fixe et disposé en regard d'un support d'un objet ou d'un patient pouvant se déplacer par rapport audit dispositif d'aimant permanent pour amener l'objet ou l'organe du patient le long de l'axe Oz dans ladite zone d'intérêt sphérique ZI.

12. Dispositif d'aimant permanent selon l'une quelconque des revendications 1 à 11, **caractérisé en ce qu'**un espace libre au centre de ladite deuxième couronne principale (2 ; 102 ; 202) annulaire est obturé au moins partiellement par un bloc cylindrique supplémentaire (56 ; 66 ; 76) en matériau magnétique avec une aimantation axiale.

13. Procédé de réalisation d'un dispositif d'aimant permanent pour la création d'un champ magnétique homogène avec génération d'une composante de champ magnétique homogène Bz selon un axe Oz dans une zone d'intérêt sphérique ZI de centre O et de rayon r, comprenant les étapes suivantes :

    a) préparer et positionner au moins une première couronne principale (1; 101; 201) annulaire en matériau magnétique avec une aimantation radiale orientée selon un premier sens, ayant ledit axe Oz, un premier rayon interne (a11), un premier rayon externe (a12) et s'étendant autour d'une ouverture (24; 124; 224) d'accès à ladite zone d'intérêt ZI,

    b) préparer et positionner une deuxième couronne principale (2; 102; 202) annulaire en matériau magnétique avec une aimantation radiale orientée selon ledit premier sens, ayant ledit axe Oz, un deuxième rayon interne (a21), un deuxième rayon externe (a22) et déportée selon ledit axe Oz par rapport à ladite première couronne (1; 101; 201) annulaire et ladite zone d'intérêt ZI, le deuxième rayon interne (a21) et le deuxième rayon externe (a22) de la deuxième couronne principale (2; 102; 202) annulaire étant respectivement inférieurs au premier rayon interne (a11) et au premier rayon externe (a12) de la première couronne principale (1; 101; 201), et

    c) préparer et positionner un ensemble cylindrique correcteur (10; 110; 210) d'axe Oz disposé d'une part entre la première couronne principale (1; 101; 201) annulaire et la zone d'intérêt ZI et d'autre part entre la deuxième couronne principale (2; 102; 202) annulaire et la zone d'intérêt ZI et comprenant à partir du voisinage de ladite ouverture (24; 124; 224) au moins une première couronne complémentaire (4; 104; 204) annuaire en matériau magnétique avec une aimantation radiale orientée selon un sens opposé audit premier sens, et au moins une deuxième couronne complémentaire (5; 105; 205) annulaire en matériau magnétique avec une aimantation radiale orientée selon ledit premier sens, les couronnes complémentaires superposées (4 à 9, 104 à 106; 204 à 209, 211) composant ledit ensemble cylindrique correcteur (10 ; 110 ; 210) présentant le même rayon interne et le même rayon externe, ledit procédé étant **caractérisé en ce que** ledit même rayon interne des couronnes complémentaires superposées (4 à 9 ; 104 à 106 ; 204 à 209, 211) est égal au deuxième rayon interne (a21) de la couronne principale (2 ; 102 ; 202) annulaire et **en ce que** ledit même rayon externe des couronnes complémentaires superposées (4 à 9 ; 104 à 106 ; 204 à 209, 211) est inférieur au premier rayon interne (a11) de la première couronne principale (1 ; 101 ; 201) annulaire.

14. Procédé selon la revendication 13, **caractérisé en ce que** pour ajuster l'espacement entre les couronnes complémentaires (4 à 9 ; 104, 105 ; 204 à 209, 211) on intercale dans l'ensemble cylindrique correcteur (10 ; 110 ; 210) des couronnes intercalaires en matériau non magnétique.

15. Procédé selon la revendication 13 ou la revendication 14, **caractérisé en ce que** l'on réalise au moins certaines des couronnes annulaires en matériau magnétique sous forme de couronnes polygonales définies par des cylindres circulaires approchés par des lignes polygonales et réalisées à partir d'un assemblage de N prismes droits identiques (31 à 42) ayant une base trapézoïdale isocèle.

**16.** Procédé selon la revendication 15, **caractérisé en ce que** la réalisation d'une couronne polygonale est effectuée selon les étapes suivantes :

> i) fabrication par pressage ou frittage de blocs parallélépipédiques possédant une direction privilégiée d'aimantation;
> ii) taille des blocs parallélépipédiques à l'état désaimanté pour créer des prismes;
> iii) aimantation de chacun des prismes dans la direction souhaitée ;
> iv) assemblage et collage des prismes pour créer une couronne polygonale.

**Patentansprüche**

**1.** Permanentmagnetvorrichtung zur Erzeugung eines homogenen Magnetfeldes, um eine homogene Magnetfeldkomponente Bz entlang einer Achse Oz in einem sphärischen Bereich von Interesse ZI mit dem Mittelpunkt O und dem Radius r zu erzeugen, wobei die Vorrichtung wenigstens einen ersten ringförmigen Hauptkranz (1; 101; 201) aus magnetischem Material mit einer in einer ersten Richtung ausgerichteten radialen Magnetisierung, der die Achse Oz, einen ersten Innenradius (a11), einen ersten Außenradius (a12) hat und um eine Zugangsöffnung (24; 124; 224) zu dem Bereich von Interesse ZI herum verläuft, einen zweiten ringförmigen Hauptkranz (2; 102; 202) aus magnetischem Material mit einer in der ersten Richtung ausgerichteten radialen Magnetisierung, der die Achse Oz, einen zweiten Innenradius (a21), einen zweiten Außenradius (a22) hat und entlang der Achse Oz gegenüber dem ersten Kranz (1; 101; 201) und dem Bereich von Interesse ZI versetzt ist, wobei der zweite Innenradius (a21) und der zweite Außenradius (a22) des zweiten Hauptkranzes (2; 102; 202) kleiner als der erste Innenradius (a11) bzw. als der erste Außenradius (a12) des ersten Hauptkranzes (1; 101; 201) sind, sowie eine zylindrische Korrekturanordnung (10; 110; 210) mit der Achse Oz umfasst, die einerseits zwischen dem ersten Hauptkranz (1; 101; 201) und dem Bereich von Interesse ZI und andererseits zwischen dem zweiten Hauptkranz (2; 102; 202) und dem Bereich von Interesse ZI angeordnet ist und die ausgehend von der Nähe der Öffnung (24; 124; 224) wenigstens einen ersten komplementären ringförmigen Kranz (4; 104; 204) aus magnetischem Material mit einer in einer zu der ersten Richtung entgegengesetzten Richtung ausgerichteten radialen Magnetisierung sowie wenigstens einen zweiten komplementären ringförmigen Kranz (5; 105; 205) aus magnetischem Material mit einer in der ersten Richtung ausgerichteten radialen Magnetisierung umfasst, und derart, dass die übereinander angeordneten komplementären Kränze (4 bis 9; 104 bis 106; 204 bis 209, 211), welche die zylindrische Korrekturanordnung (10; 110; 210) bilden, den gleichen Innenradius und den gleichen Außenradius aufweisen, wobei die Vorrichtung **dadurch gekennzeichnet ist, dass** der gleiche Innenradius der übereinander angeordneten komplementären Kränze (4 bis 9; 104 bis 106; 204 bis 209, 211) gleich dem zweiten Innenradius (a21) des ringförmigen Hauptkranzes (2; 102; 202) ist und dass der gleiche Außenradius der übereinander angeordneten komplementären Kränze (4 bis 9; 104 bis 106; 204 bis 209, 211) kleiner als der erste Innenradius (a11) des ersten ringförmigen Hauptkranzes (1; 101; 201) ist.

**2.** Permanentmagnetvorrichtung nach Anspruch 1, **dadurch gekennzeichnet, dass** sie ferner einen ringförmigen Korrekturkranz (3; 203) mit der Achse Oz aus magnetischem Material mit einer in einer zu der ersten Richtung entgegengesetzten Richtung ausgerichteten radialen Magnetisierung umfasst, der zwischen dem ersten ringförmigen Hauptkranz (1; 201) und der zylindrischen Korrekturanordnung (10; 210) angeordnet ist.

**3.** Permanentmagnetvorrichtung nach Anspruch 1 oder Anspruch 2, **dadurch gekennzeichnet, dass** die zylindrische Korrekturanordnung (10) sechs übereinander angeordnete komplementäre Kränze (4 bis 9) aus magnetischem Material mit einer radialen Magnetisierung, die für jeden nachfolgenden komplementären Kranz abwechselnd in einer zu der ersten Richtung entgegengesetzten Richtung und in der ersten Richtung ausgerichtet ist, umfasst, wobei die sechs übereinander angeordneten komplementären Kränze (4 bis 9) den ersten und den zweiten komplementären Kranz (4, 5) einschließen.

**4.** Permanentmagnetvorrichtung nach einem der Ansprüche 1 bis 3, **dadurch gekennzeichnet, dass** die zylindrische Korrekturanordnung (10; 110; 210) ferner Zwischenkränze aus nicht magnetischem Material umfasst, um den Abstand zwischen den übereinander angeordneten komplementären Kränzen (4 bis 9; 104 bis 106; 204 bis 209, 211) aus magnetischem Material mit einer radialen Magnetisierung, die für jeden nachfolgenden komplementären Kranz abwechselnd in einer zu der ersten Richtung entgegengesetzten Richtung und in der ersten Richtung ausgerichtet ist, anzupassen.

**5.** Permanentmagnetvorrichtung nach einem der Ansprüche 1 bis 4, **dadurch gekennzeichnet, dass** wenigstens einige der ringförmigen Kränze aus magnetischem Material durch polygonale Kränze gebildet sind, die durch durch polygonale Linien genäherte Kreiszylinder definiert sind und aus einer Anordnung von N identischen geraden Prismen (31 bis 42) mit einer gleichschenkligen trapezförmigen Grundfläche ausgebildet sind.

6.  Permanentmagnetvorrichtung nach Anspruch 5, **dadurch gekennzeichnet, dass** der erste und der zweite Hauptkranz (1, 2; 101, 102; 201, 202) durch polygonale Kränze, die 8, 10 oder 12 identische gerade Prismen mit einer gleichschenkligen trapezförmigen Grundfläche (31 bis 42) umfassen, gebildet sind.

7.  Permanentmagnetvorrichtung nach einem der Ansprüche 1 bis 6, **dadurch gekennzeichnet, dass** sie auf eine NMR-Anlage angewandt ist und eine Form eines Zylinderhutes (50; 60) aufweist, der einen eine Öffnung (54; 64) definierenden Rand (52; 62) und einen zylindrischen Schacht (51; 61) mit der Achse Oz aufweist, welcher die Öffnung (54; 64) fortsetzt und einen Innenhohlraum (53; 63) definiert, um die Analyse des Kopfes oder eines Teils des Kopfes eines Patienten zu ermöglichen.

8.  Permanentmagnetvorrichtung nach Anspruch 7, **dadurch gekennzeichnet, dass** sie in vertikaler Position mit nach unten liegender Öffnung (54) angebracht ist.

9.  Permanentmagnetvorrichtung nach Anspruch 7, **dadurch gekennzeichnet, dass** sie in horizontaler Position mit seitlich liegender Öffnung (64) angebracht ist.

10. Permanentmagnetvorrichtung nach einem der Ansprüche 1 bis 6, **dadurch gekennzeichnet, dass** sie auf eine MRT-Mammographie-Anlage angewandt ist und eine Form eines umgekehrten Zylinderhutes (70) aufweist, der einen eine obere Öffnung (74) definierenden Rand (72) und einen zylindrischen Schacht (71) mit der Achse Oz aufweist, welcher die Öffnung (74) fortsetzt und einen Innenhohlraum (73) definiert, um die Analyse einer Brust oder eines Teils der Brust einer Patientin zu ermöglichen.

11. Permanentmagnetvorrichtung nach einem der Ansprüche 1 bis 10, **dadurch gekennzeichnet, dass** sie in fester Position ist und gegenüber einem Träger eines Gegenstands oder eines Patienten angeordnet ist, der sich gegenüber der Permanentmagnetvorrichtung bewegen kann, um den Gegenstand oder das Organ des Patienten entlang der Achse Oz in den sphärischen Bereich von Interesse ZI zu bringen.

12. Permanentmagnetvorrichtung nach einem der Ansprüche 1 bis 11, **dadurch gekennzeichnet, dass** ein Freiraum in der Mitte des zweiten ringförmigen Hauptkranzes (2; 102; 202) wenigstens teilweise durch einen zusätzlichen zylindrischen Block (56; 66; 76) aus magnetischem Material mit einer axialen Magnetisierung verschlossen ist.

13. Verfahren zur Herstellung einer Permanentmagnetvorrichtung zur Erzeugung eines homogenen Magnetfeldes mit Erzeugung einer homogenen Magnetfeldkomponente Bz entlang einer Achse Oz in einem sphärischen Bereich von Interesse ZI mit dem Mittelpunkt O und dem Radius r, umfassend die folgenden Schritte:

    a) Vorbereiten und Positionieren wenigstens eines ersten ringförmigen Hauptkranzes (1; 101; 201) aus magnetischem Material mit einer in einer ersten Richtung ausgerichteten radialen Magnetisierung, der die Achse Oz, einen ersten Innenradius (a11), einen ersten Außenradius (a12) hat und um eine Zugangsöffnung (24; 124; 224) zu dem Bereich von Interesse ZI herum verläuft,

    b) Vorbereiten und Positionieren eines zweiten ringförmigen Hauptkranzes (2; 102; 202) aus magnetischem Material mit einer in der ersten Richtung ausgerichteten radialen Magnetisierung, der die Achse Oz, einen zweiten Innenradius (a21), einen zweiten Außenradius (a22) hat und entlang der Achse Oz gegenüber dem ersten ringförmigen Kranz (1; 101; 201) und dem Bereich von Interesse ZI versetzt ist, wobei der zweite Innenradius (a21) und der zweite Außenradius (a22) des zweiten ringförmigen Hauptkranzes (2; 102; 202) kleiner als der erste Innenradius (a11) bzw. als der erste Außenradius (a12) des ersten Hauptkranzes (1; 101; 201) sind, und

    c) Vorbereiten und Positionieren einer zylindrischen Korrekturanordnung (10; 110; 210) mit der Achse Oz, die einerseits zwischen dem ersten ringförmigen Hauptkranz (1; 101; 201) und dem Bereich von Interesse ZI und andererseits zwischen dem zweiten ringförmigen Hauptkranz (2; 102; 202) und dem Bereich von Interesse ZI angeordnet ist und die ausgehend von der Nähe der Öffnung (24; 124; 224) wenigstens einen ersten komplementären ringförmigen Kranz (4; 104; 204) aus magnetischem Material mit einer in einer zu der ersten Richtung entgegengesetzten Richtung ausgerichteten radialen Magnetisierung sowie wenigstens einen zweiten komplementären ringförmigen Kranz (5; 105; 205) aus magnetischem Material mit einer in der ersten Richtung ausgerichteten radialen Magnetisierung umfasst, wobei die übereinander angeordneten komplementären Kränze (4 bis 9; 104 bis 106; 204 bis 209, 211), welche die zylindrische Korrekturanordnung (10; 110; 210) bilden, den gleichen Innenradius und den gleichen Außenradius aufweisen, wobei das Verfahren **dadurch gekennzeichnet ist, dass** der gleiche Innenradius der übereinander angeordneten komplementären Kränze (4 bis 9; 104 bis 106; 204 bis 209, 211) gleich dem zweiten Innenradius (a21) des ringförmigen Hauptkranzes (2; 102; 202) ist und dass der gleiche Außenradius der übereinander angeordneten komplementären Kränze (4 bis 9; 104 bis 106; 204 bis 209, 211) kleiner als der erste Innenradius (a11) des ersten ringförmigen Hauptkranzes (1; 101; 201) ist.

14. Verfahren nach Anspruch 13, **dadurch gekennzeichnet, dass** zur Anpassung des Abstandes zwischen den komplementären Kränzen (4 bis 9; 104, 105; 204 bis 209, 211) Zwischenkränze aus nicht magnetischem Material in die zylindrische Korrekturanordnung (10; 110; 210) eingefügt werden.

15. Verfahren nach Anspruch 13 oder Anspruch 14, **dadurch gekennzeichnet, dass** wenigstens einige der ringförmigen Kränze aus magnetischem Material in Form von polygonalen Kränzen ausgebildet werden, die durch durch polygonale Linien genäherte Kreiszylinder definiert sind und aus einer Anordnung von N identischen geraden Prismen (31 bis 42) mit einer gleichschenkligen trapezförmigen Grundfläche ausgebildet sind.

16. Verfahren nach Anspruch 15, **dadurch gekennzeichnet, dass** die Ausbildung eines polygonalen Kranzes gemäß den folgenden Schritten vollzogen wird:

i) Herstellen durch Pressen oder Sintern von quaderförmigen Blöcken, die eine bevorzugte Magnetisierungsrichtung besitzen,
ii) Zuschneiden der quaderförmigen Blöcke im entmagnetisierten Zustand, um Prismen herzustellen,
iii) Magnetisieren eines jeden der Prismen in der gewünschten Richtung,
iv) Verbinden und Kleben der Prismen, um einen polygonalen Kranz herzustellen.

**Claims**

1. A permanent magnet device for creating a homogeneous magnetic field to generate a homogeneous magnetic field component Bz along an axis Oz in a spherical zone of interest ZI of centre O and radius r, the device comprising at least one first main annular ring (1; 101; 201) in magnetic material with radial magnetization oriented in a first direction, having said axis Oz, a first inner radius (a11), a first outer radius (a12) and extending around an opening (24; 124; 224) giving access to said zone of interest ZI, a second main annular ring (2; 102; 202) in magnetic material with radial magnetization oriented in said first direction, having said axis Oz, a second inner radius (a21), a second outer radius (a22) and offset along said axis Oz from said first ring (1; 101; 201) and said zone of interest ZI, the second inner radius (a21) and the second outer radius (a22) of the second main ring (2; 102; 202) respectively being smaller than the first inner radius (a11) and the first outer radius (a12) of the first main ring (1; 101; 201), and a cylindrical corrector assembly (10; 110; 210) of axis Oz arranged between the first main ring (1; 101; 201) and the zone of interest ZI and between the second main ring (2; 102; 202) and the zone of interest ZI and comprising - starting from the vicinity of said opening (24; 124; 224) - at least one first supplementary annular ring (4; 104; 204) in magnetic material with radial magnetization oriented in an opposite direction to said first direction, and at least one second supplementary annular ring (5; 105; 205) in magnetic material with radial magnetization oriented in said first direction, and such that the superimposed supplementary rings (4 to 9; 104 to 106; 204 to 209, 211) forming said cylindrical corrector assembly (10; 110; 210) have the same inner radius and the same outer radius, said device being **characterized in that** said same inner radius of the superimposed supplementary rings (4 to 9; 104 to 106; 204 to 209, 211) is equal to the second inner radius (a21) of the second main annular ring (2; 102 ; 202) and **in that** the same outer radius of said superimposed supplementary rings (4 to 9; 104 to 106; 204 to 209, 211) is smaller than the first inner radius (a11) of the first main annular ring (1; 101; 201).

2. The permanent magnet device according to claim 1, **characterized in that** it also comprises an annular corrector ring (3; 203) of axis Oz in magnetic material with radial magnetization oriented in opposite direction to said first direction, arranged between said first main annular ring (1; 201) and said cylindrical corrector assembly (10; 210).

3. The permanent magnet device according to claim 1 or claim 2, **characterized in that** the cylindrical corrector assembly (10) comprises six superimposed supplementary rings (4 to 9) in magnetic material with radial magnetization which, for each successive supplementary ring, is oriented alternately in opposite direction to said first direction and in said first direction, said six superimposed rings (4 to 9) including said first and second supplementary rings (4, 5).

4. The permanent magnet device according to any of claims 1 to 3, **characterized in that** said cylindrical corrector assembly (10; 110; 210) further comprises intercalary rings in non-magnetic material to adjust the spacing between the superimposed supplementary rings (4 to 9; 104 to 106; 204 to 209, 211) in magnetic material with radial magnetization which, for each successive supplementary ring, is oriented alternately in opposite direction to said first direction and in said first direction.

5. The permanent magnet device according to any of claims 1 to 4, **characterized in that** at least some of the annular rings in magnetic material are formed by polygonal rings defined by circular cylinders approximated by polygonal lines and formed from an assembly of N identical right prisms (31 to 42) having an isosceles trapezoidal base.

6. The permanent magnet device according to claim 5, **characterized in that** the first and second main rings (1, 2; 101, 102; 201, 202) are formed by polygonal rings comprising 8, 10 or 12 identical right prisms having an isosceles trapezoidal base.

7. The permanent magnet device according to any of claims 1 to 6, **characterized in that** it is applied to a NMR installation and is in the form of a top hat (50; 60) having a rim (52; 62) defining an opening (54; 64) and a cylindrical chimney (51; 61) of axis Oz extending said opening (54; 64) and defining an inner cavity (53; 63) to allow the analysis of a patient's head or head portion.

8. The permanent magnet device according to claim 7, **characterized in that** it is installed in vertical position with the opening (54) at the bottom.

9. The permanent magnet device according to claim 7, **characterized in that** it is installed in horizontal position with the opening (64) positioned laterally.

10. The permanent magnet device according to any of claims 1 to 6, **characterized in that** it is applied to a MRI mammography installation and is in the form of an inverted top hat (70) having a rim (72) defining an upper opening (74) and a cylindrical well (71) of axis Oz extending said opening (74) and defining an inner cavity (73) to allow the analysis of a patient's breast or breast portion.

11. The permanent magnet device according to any of claims 1 to 10, **characterized in that** it is in fixed position and arranged facing a support supporting an object or a patient able to be moved relative to said permanent magnet device to bring the object or the organ of the patient along the axis Oz into said spherical zone of interest ZI.

12. The permanent magnet device according to any of claims 1 to 11, **characterized in that** a free space in the centre of said second main annular ring (2; 102; 202) is shut off at least partly by an additional cylindrical block (56; 66; 76) in magnetic material with an axial magnetization.

13. A method for producing a permanent magnet device to create a homogeneous magnetic field with generation of a homogeneous magnetic field component Bz along an axis Oz in a spherical zone of interest ZI of centre O and radius r, comprising the following steps:

    a) preparing and positioning at least one first main annular ring (1; 101; 201) in magnetic material with radial magnetization oriented in a first direction, having said axis Oz, a first inner radius (a11), a first outer radius (a12) and extending around an opening (24; 124; 224) giving access to said zone of interest ZI,
    b) preparing and positioning a second main annular ring (2; 102; 202) in magnetic material with radial magnetization oriented in said first direction, having said axis Oz, a second inner radius (a21), a second outer radius (a22) and offset along said axis Oz from said first annular ring (1; 101; 201) and said zone of interest ZI, the second inner radius (a21) and the second outer radius (a22) of the second main annular ring (2; 102; 202) respectively being smaller than the first inner radius (a11) and the first outer radius (a12) of the first main ring (1; 101; 201), and
    c) preparing and positioning a cylindrical corrector assembly (10; 110; 210) of axis Oz arranged between the first main annular ring (1; 101; 201) and the zone of interest ZI and between the second main annular ring (2; 102; 202) and the zone of interest ZI and comprising - starting from the vicinity of said opening (24; 124; 224) - at least one first supplementary annular ring (4; 104; 204) in magnetic material with radial magnetization oriented in opposite direction to said first direction, and at least one second additional annular ring (5; 105; 205) in magnetic material with radial magnetization oriented in said first direction, the superimposed additional rings (4 to 9; 104 to 106; 204 to 209, 211) forming said cylindrical corrector assembly (10; 110; 210) having the same inner radius and the same outer radius, said method being **characterized in that** said same inner radius of said superimposed additional rings (4 to 9; 104 to 106; 204 to 209, 211) is equal to the second inner radius (a21) of the second main annular ring (2; 102; 202) and **in that** same outer radius of said superimposed additional rings (4 to 9; 104 to 106; 204 to 209, 211) is smaller than the first inner radius (a11) of the first main annular ring (1; 101; 201).

14. The method according to claim 13, **characterized in that** to adjust the spacing between the supplementary rings (4 to 9; 104, 105; 204 to 209, 211) intercalary rings in non-magnetic material are inserted in the cylindrical corrector assembly (10; 110; 210).

15. The method according to claim 13 or claim 14, **characterized in that** at least some of the annular rings in magnetic material are made in the form of polygonal rings defined by circular cylinders approximated by polygon lines and formed from an assembly of N identical right prisms (31 to 42) having an isosceles trapezoidal base.

16. The method according to claim 15, **characterized in that** the forming of a polygonal ring is carried out using the following steps:

i) forming parallelepiped blocks by pressing or sintering, having a priority magnetization direction;
ii) cutting the parallelepiped blocks in the de-magnetized state to create prisms;
iii) magnetizing each of the prisms in the desired direction;
iv) assembling and bonding the prisms to create a polygonal ring.

FIG.1

FIG.1A

FIG.2

FIG.3

FIG.4

FIG.4A

FIG.5

FIG.6

FIG.7

FIG.7A

FIG.10

FIG.8

FIG.9

FIG.11

FIG.12

FIG.13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• EP 0541653 B1

**Littérature non-brevet citée dans la description**

• **KLAUS HALBACH.** Design of permanent multiple magnets with oriented rare earth cobalt material. *Nucl. Instr. And Meth.,* 1980, vol. 169, 1-10